Europäisches Patentamt

European Patent Office

Office européen des brevets

(11) Veröffentlichungsnummer: **0 121 092**
**A1**

(12) **EUROPÄISCHE PATENTANMELDUNG**

(21) Anmeldenummer: **84102036.5**

(22) Anmeldetag: **27.02.84**

(51) Int. Cl.³: **F 24 F 5/00**
**H 01 L 49/00**

(30) Priorität: **28.02.83 DE 3306997**

(43) Veröffentlichungstag der Anmeldung:
**10.10.84 Patentblatt 84/41**

(84) Benannte Vertragsstaaten:
**AT CH FR GB IT LI SE**

(71) Anmelder: **Bschorr, Oskar, Dr. rer. nat.**
**Keplerstrasse 11**
**D-8000 München 80(DE)**

(72) Erfinder: **Bschorr, Oskar, Dr. rer. nat.**
**Keplerstrasse 11**
**D-8000 München 80(DE)**

(54) **Erzeugung von Temperaturdifferenzen.**

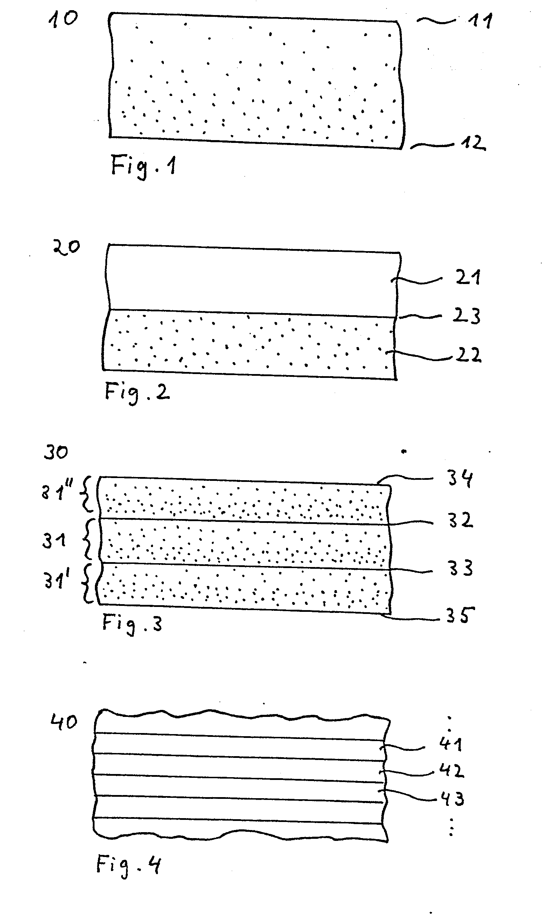

(57) Es ist die Aufgabe gestellt, Temperaturdifferenzen zur Heizung undKühlung zu erzeugen. Dazu wird der thermo-motorische Effekt ausgenützt. Unter dem Einfluß eines Dotierungsgradienten stellt sich in einem elektrisch isolieren-den Festkörper ein Temperaturgradient ein. Die Dotierung bezieht sich dabei auf die innere Energie, die freie Weglänge und die Geschwindigkeiten der wärmeleitenden Phononen (Fig. 1).

Fig. 1

## Erzeugung von Temperaturdifferenzen

O. Bschorr

Die Erfindung bezieht sich auf die Erzeugung von Temperaturdifferenzen, insbesondere zur Heizung und Kühlung. Dazu wird der thermomotorische Effekt, der sich an einem inhomogenen Festkörper, bzw. an der Kontaktstelle zweier verschiedener Festkörper einstellt, ausgenützt werden.

Zunächst soll die zum Verständnis und zur Dimensionierung notwendige Theorie zusammengestellt werden. Der Einfachheit halber soll die Ableitung auf isotrope Festkörper beschränkt werden. Anisotrope Stoffe können durch eine energieäquivalente, mittlere Kugelcharakteristik auf die Isotropie zurückgeführt werden. Im weiteren wird davon ausgegangen, daß Diffusuions- und Transportvorgänge gegenüber der Wärmeleitung vernachlässigt werden können. Im wesentlichen sind dadurch Elektronenleiter von der Theorie nicht erfaßt.

Aus der Wärmestrahlung ist der Kirchhoff'sche Satz bekannt, der die Strahlungsintensität $i(\nu)$ , den Absorptionskoeffizienten $\alpha(\nu)$ und die Emission $\varepsilon(\nu)$ durch die Beziehung ( $\nu$ = Frequenz)

$$\varepsilon(\nu) = \alpha(\nu) \, i(\nu)$$

miteinander verknüpft. Im weiteren besteht für isotrope Strahlungsverhältnisse der Satz

$$i(\nu) = u(\nu) \, c / 4\pi$$

mit dem die Strahlungsintensität $i(\nu)$ durch die Energiedichte $u(\nu)$ und die Ausbreitungsgeschwindigkeit c ( = Lichtgeschwindigkeit) ersetzt.

Führt man anstelle des Absorptionskoeffizienten $\alpha$ die hier zweck-mäßigere, freie Weglänge $l(\nu)$ nach

$$\alpha(\nu) = 1/l(\nu)$$

ein, so erhält man insgesamt die Ausgangsformel

$$\varepsilon(\nu) = u(\nu)\, c\,/\, 4\pi\, l(\nu)$$

die für alle Lichtfrequenzen $\nu$ im stationären Zustand gültig ist. Diese Ausgangsbasis wird in 2 Punkten erweitert: Einmal wird diese, für Lichtstrahlung ( = Photonenstrahlung) geltende Theorie auf die Phononenstrahlung im Festkörper übertragen. Zum zweiten wird diese Kirchhoff'sche Emissions/Absorptionsbilanz, die nur für ein homogenes Strahlungsfeld gültig ist, auf einen inhomogenen Festkörper ausgedehnt. Die erste Annahme ist unmittelbar anschaulich. Für alle eingeführten Parameter $u$, c und l existieren beim Festkörper Entsprechungen und sind bekannte, tabellierte Größen. $u$ ist die Energiedichte, c bedeutet hier die Phononengeschwindigkeit und l deren freien Weglänge bis zur Absorption und anschließenden Emission. Dabei ist es nicht notwendig, diese Wechselwirkungsmechanismen im einzelnen zu kennen. Gegenüber der Photonenstrahlung ist beim Festkörper jedoch zu beachten, daß es mehrere Phononenarten gibt und daß die Phononengeschwindigkeit arten- und frequenzabhängig ist. Der Übersichtlichkeit halber und da technisch nur die Gesamtenergien interessieren, soll zu folgenden jeweils mit den effektiven Mittelwerten gerechnet werden. Im besonderen soll $u$ nach

$$u = \sum_{n=1}^{N} \int_{0}^{\infty} u_n(\nu)\, d\nu$$

die über alle Phononenarten n und Frequenzen $\nu$ summierte, gesamte innere Energie sein.

Ebenso sind mittlere Geschwindigkeit c und mittlere, freie Weglänge l
so gebildet, daß für die Globalwerte wieder das Kirchhoff-Emissions/
Absorptionsgleichgewicht

$$\varepsilon = u c / 4 \pi \ell$$

gilt. Darin sind auch die optischen Phononen erfaßt, die lokal gebunden
sind und für die $c_n = 0$ anzusetzen ist.

Die Emissionsbeziehung $\varepsilon$ gilt zunächst nur für einen homogenen Festkörper.
Sind jedoch die Änderungsgradienten in einem inhomogenen Festkörper klein
gegenüber der freien Weglänge l, so kann dieser ohne Einschränkung lokal
als quasihomogen und quasiisotrop behandelt werden. Die Inhomogenität kann
durch Gradientenmischung, Diffusion, Gitterstörungen, Ionenimplantation usw.
erreicht sein und soll im folgenden durch den Sammelbegriff "Dotierung" beschrieben sein. Die durch Dotierung bewirkte Inhomogenität sei $d\varepsilon_{Dot}/dx =$
$\varepsilon'_{Dot}$. Während beim homogenen Körper im stationären Zustand gleiche Temperatur herrscht und keine freien Energie(= Wärme)flüsse bestehen, hat der
isotherme, inhomogene Festkörper den Wärmefluß q

$$q = \pi \ell^2 \varepsilon'_{Dot}$$

Dieser hält so lange an, bis sich im stationären Energiezustand ein Temperaturgradient T' ausbildet, bei dem der Wärmefluß q = 0 verschwindet.

$$T' = - \frac{d\varepsilon_{Dot}/dx}{d\varepsilon/dT} = - \frac{\frac{u'_{Dot}}{u} + \frac{c'_{Dot}}{c} - \frac{\ell'_{Dot}}{\ell}}{\frac{du}{u\,dT} + \frac{dc}{c\,dT} - \frac{d\ell}{\ell\,dT}}$$

Mit der Wärmeleitfähigkeit $\lambda$ vereinfacht sich

$$T' = - \frac{uc\ell}{4\lambda} \left( \frac{u'_{Dot}}{u} + \frac{c'_{Dot}}{c} - \frac{\ell'_{Dot}}{\ell} \right)$$

Aufgabe der Erfindung ist es, diesen thermomotorischen Effekt anzuwenden und zu optimieren, Verfahren zur Herstellung thermomotorischer Elemente anzugeben und vorteilhafte Ausführungsformen zu.beschreiben. Dies soll anhand von 4 Beispielen erfolgen:

Fig. 1    Einstufiges thermomotorisches Element mit
          inhomogenem Festkörper

Fig. 2    Einstufiges thermomotorisches Element
          mit 2 verschiedenen Festkörpern

Fig. 3    Mehrstufiges thermomotorisches Element

Fig. 4    Mehrstufiges thermomotorisches Element
          in Folienschichtung

In Fig. 1 ist ein thermomotorisches Element 10 dargestellt. Es besteht aus einem Festkörper mit hoher Wärmeleitung durch Phononen, insb. aus dielektrischen Stoffen, z.B. hochreinem Aluminiumoxyd-Kristall. Das Element 10 hat eine Flächenform mit einer Mindestschichtdicke von mehreren freien Weglängen l der Phononen. In Richtung zur Schichtnormalen weist das Element 10 eine Inhomogenität infolge Dotierung auf. Zur Dotierung können grundsätzlich die zur Halbleiterdotierung angewendeten Verfahrensweisen übertragen werden. Zum Beispiel wird bei erhöhter Temperatur von der Schichtseite 12 her ein Isotop eindiffundiert. Ändert sich dadurch zwischen den Schichtseiten 12 und 11 die innere Energie kontinuierlich von $u$ zu $u + \Delta u_{Dot}$, die freie Weglänge von l zu $l + \Delta l_{Dot}$ und die Phononengeschwindigkeit von c zu $c + \Delta l_{Dot}$, so liegt an den Schichtseiten die Temperaturdifferenz $\Delta T_A$ an

$$\Delta T_A = - \frac{uc l}{4\lambda} \left( \frac{\Delta u_{Dot}}{u} + \frac{\Delta c_{Dot}}{c} - \frac{\Delta l_{Dot}}{l} \right)$$

(Hierbei handelt es sich um eine linearisierte Gleichung gültig für $\Delta u_{Dot} \ll u$, $\Delta c_{Dot} \ll c$ und $\Delta l_{Dot} \ll l$). Eine solche Differenz kann in einfacher Weise für Heiz- und Kühlzwecke ausgenützt werden. Beide Schichtseiten 11 und 12 mit z.B. Luft, Wasser beaufschlagt, kühlt sich die eine Seite ab, während die andere um dieselbe Wärmemenge aufgeheizt wird. Zweckmäßigerweise werden mit mehreren thermomotorischen Elementen 10 Kanäle gebildet, die abwechselnd von dem aufzuheizenden und dem abzukühlenden Medium durchströmt sind. Schließlich ist es aus Festigkeitsgründen und als Berührungsschutz möglich, das thermomotorische Element 10 beidseitig mit Träger- und Schutzschichten zu versehen.

Fig. 2 zeigt den Grundaufbau eines thermomotorischen Elementes 20, bestehend aus 2 Schichten 21 und 22, die an der Fläche 23 festen Kontakt haben. Die Schichten 21 und 22 sind jeweils homogen und haben die inneren Energien $u_1$ und $u_2$ und die Phononengeschwindigkeit $c_1$ und $c_2$. Sie bestehen wie in Fig. 1 aus Festkörpern mit hoher Wärmeleitung durch Phononen. Von der Schicht 21 liegt so der Energiefluß $i_1 = \frac{1}{8} u_1 c_1$ und von der Schicht 22 der Fluß $i_2 = \frac{1}{8} u_2 c_2$ an der Kontaktfläche 23 an. Mit den Transmissionsgraden $\Upsilon_{12}$ und $\Upsilon_{21}$ tritt der Energiestrom $q_1 = \Upsilon_{12} i_1$ von der Schicht 21 nach 22 und der Strom $q_2 = \Upsilon_{21} i_2$ in Gegenrichtung. Im stationären Energiegleichgewicht ist $q_1 = q_2$. Bei unterschiedlichen Stoffkonstanten der Schichten 21 und 22 wird die $q_1 = q_2$ - Bedingung durch eine sich einstellende Temperaturdifferenz $\Delta T_B$ erreicht. Mit der Linearisierung $u_1 = u$; $u_2 = u + \Delta u$ ; $c_1 = c$; $c_2 = c + \Delta c$ ist

$$\Delta T_B = \frac{\Upsilon_{21}}{\Upsilon_{12}} \quad \frac{\Delta u/u + \Delta c/c}{\frac{1}{u}\frac{du}{dT} + \frac{1}{c}\frac{dc}{dT}}$$

Unterstellt man das Reziprozitätstheorem, so kann man $\Upsilon_{12} = \Upsilon_{21}$ setzen. - Eine solche thermomotorische Kraft kann, wie in Fig. 1 beschrieben, wieder zu Heiz- und Kühlzwecken verwendet werden. Da ein thermomotorisches Element nach Fig. 2 einfacher herzustellen ist, als nach Fig. 1), kann dieses auch zur Unterstützung des Wärmehaushaltes von Außenwänden verwendet werden. Vorteilhaft hierbei ist die Gleichrichterwirkung des Elementes. Diese verhält sich gegenüber einem wechselnden Wärmestrom, z.B. infolge des Tag/ Nachtunterschiedes analog wie eine Diode. Für die unterschiedlichen Stromrichtungen hat das thermomotorische Element infolge der anliegenden Temperaturdifferenz unterschiedlichen Wärmewiderstand. Auf diese Weise findet eine Gleichrichtung statt; in der Heizperiode ist diese so ausgelegt, daß sie einen hohen Wärmewiderstand von innen nach außen aufweist, während der Durchlaßwiderstand in Gegenrichtung die Tageserwärmung nach innen frei gibt.

Fig. 3 stellt ein thermomotorisches Element 30, das aus mehreren Schichten 31, 31' ... besteht. Die Schichten 31, 31' ... weisen in Schichtnormalen einen Gradienten infolge Dotierung auf. Analog zu Fig. 1 liegt an den Schichtseiten 32 und 33 deshalb eine Temperaturdifferenz $\Delta T_A$ an.

$$\Delta T_A = - \frac{u c \ell}{4 \lambda} \left( \frac{\Delta u_{Dot}}{u} + \frac{\Delta c_{Dot}}{c} - \frac{\Delta \ell_{Dot}}{\ell} \right)$$

An die Schichtseiten 32 und 33 schließen sich in festem Kontakt die Nachbarschichten 31' und 31" an. Analog zu Fig. 2 bildet sich dadurch eine Temperaturdifferenz $\Delta T_B$ aus ($\Upsilon_{12} = \Upsilon_{21}$)

$$\Delta T_B = \frac{\frac{\Delta u_{Dot}}{u} + \frac{\Delta c_{Dot}}{c}}{\frac{1}{u} \frac{du}{dT} + \frac{1}{c} \frac{dc}{dT}}$$

$\Delta T_A$ und $\Delta T_B$ sind entgegengesetzt gerichtet, heben sich aber im allgemeinen Fall nicht auf. Die pro Schicht 31 erreichbare Temperaturdifferenz $\Delta T$ ist

$$\Delta T = \Delta T_A + \Delta T_B$$

Für den Sonderfall, daß die Schichten aus identischen Materialien bestehen, bei denen durch Fehlstellendotierung lediglich die freie Weglänge um $\Delta l$ verändert wird, aber keine Änderung der inneren Energie $u$ und der Phononengeschwindigkeit c stattfindet, ist $\Delta T$

$$\Delta T = \frac{u c}{4 \lambda} \Delta \ell$$

Bei n Schichten beträgt so die Gesamttemperaturdifferenz $\Delta T_{ges} = n \Delta T$, so daß damit eine größere thermomotorische Kraft zur Verfügung steht. Die Anwendungen sind wieder analog zu Fig. 1 und Fig. 2.

In Fig. 4 schließlich ist ein thermomotorisches Element 40, bestehend aus mehreren Schichten 41, 42, 43 ... Die einzelnen Schichten sind in sich homogen, weisen aber unterschiedliche innere Energie $u$ und Phononengeschwindigkeit c auf. Hat die Schicht 41 die Werte $u_1$ und $c_1$, die Schicht 42 die Werte $u_2$ und $c_2$ usw., so sind die n Schichten so angeordnet, daß

$$c_1 u_1 < c_2 u_2 < c_3 u_3 \ldots \qquad < c_n u_n$$

besteht. An den Kontaktstellen der Schichten tritt wieder eine Temperaturdifferenz $\Delta T_B$ nach Fig. 2 auf. Wegen der angegebenen Größenrelation hat diese immer gleiches Vorzeichen, so daß sich die thermomotorischen Effekte aufaddieren. Die Mindestdicke der Schichten beträgt wieder mehrere freie Weglängen l. Wieder ist auch die Wärmeleitung durch Elektronen ausgeschlossen, da sich dann Spannungspotentiale an den Kontaktstellen ausbilden, durch die der thermomotorische Effekt verschlechtert wird. Die Anwendung ist wieder analog zu Fig. 1 und Fig. 2. Darüber hinaus eignet sich von den geringeren Herstellungskosten her eine solche Ausführungsform für großflächige Wärme/Kälteisolierungen. Dazu ist es vorteilhaft, wenn das Schichtmaterial schlechte Wärmeleitung aufweist.

In allen Ausführungsformen nach Fig. 1 bis Fig. 4 besteht die Möglichkeit, die Temperatur der Heiz- bzw. Kühlströme über deren Mengenverhältnis zu regeln. Tritt das Medium mit der Temperatur $T_o$ in ein thermomotorisches Element mit der Arbeitsdifferenz $\Delta T$ ein und hat der Heizstrom den Mengendurchsatz $m_H$ und der abzukühlende Strom den Durchsatz $m_K$, so sind deren Endtemperaturen $T_H$ und $T_K$

$$T_H = T_o + \frac{m_K}{m_H + m_K} \Delta T$$

$$T_K = T_o - \frac{m_H}{m_H + m_K} \Delta T$$

Ebenso ist es möglich, durch die Strömungsführung die Endtemperaturen in weitem Bereich zu variieren. Bei einer - aus der Wärmetechnik bekannten - Kreuzströmung erhält man ein breites Spektrum der Temperaturverteilung. Mit mehreren hintereinandergeschalteten, thermomotorischen Elementen kann ebenfalls die Temperaturdifferenz vergrößert werden.

## Schutzansprüche

1. Erzeugung von Temperaturdifferenzen, dadurch gekennzeichnet, daß in einem Festkörper mit Wärmeleitung durch Phononen, z.B. dielektrische Stoffe, ein inhomogener Verlauf der inneren Energie $u$, der Phononengeschwindigkeit c und/oder der mittleren, freien Weglänge 1 der Phononen durch Gradientendotierung und/oder durch Schichtung ein thermomotorischer Effekt erzeugt wird, und daß die Abschlußseiten des Festkörpers, an denen in Richtung des Inhomogenitätsgradienten eine Temperaturdifferenz auftritt, mit dem aufzuheizenden bzw. dem zu kühlenden Medium beaufschlagt sind (Fig. 1).

2. Erzeugung von Temperaturdifferenzen nach Anspruch 1, dadurch gekennzeichnet, daß die Inhomogenität im Festkörper durch Dotierung, insb. durch Gradientendiffusion von Isotopen- oder Fremdatomen, durch Implantation von Gitterfehlstellen, durch Mischkristallisation und entsprechend den in der Halbleitertechnik angewendeten Dotierungsverfahren eingestellt wird.

3. Erzeugung von Temperaturdifferenzen nach den Ansprüchen 1 und 2, dadurch gekennzeichnet, daß die dotierten, inhomogenen Festkörper in Schichtform hergestellt sind und in identischer Schichtung bei festem Kontakt mit Phononenübergang zur Erhöhung der thermomotorischen Temperaturdifferenz übereinandergestapelt sind, und daß die Mindestdicke einer Schicht mehrere freie Weglängen der Phononen umfaßt (Fig.3).

4. Erzeugung von Temperaturdifferenzen nach dem Anspruch 1, dadurch gekennzeichnet, daß mehrere, verschiedene Schichten mit in sich homogenen, phononenleitenden Festkörpern so in festem Kontakt gestapelt sind, daß innere Energie $u$ und Phononengeschwindigkeit c der n.ten und der (n + 1)ten Schicht, jeweils nach der Relation $u_n c_n < u_{n+1} c_{n+1}$ eingestellt sind (Fig. 4).

5. Erzeugung von Temperaturdifferenzen nach den Ansprüchen 1 bis 4, dadurch gekennzeichnet, daß die Außenseiten der inhomogenen, thermomotorischen Festkörper mit Schutz- bzw. Trägerschichten versehen sind.

6. Erzeugung von Temperaturdifferenzen nach den Ansprüchen 1 bis 5, dadurch gekennzeichnet, daß der thermomotorische Effekt analog der Anwendung bei elektrischen Gleichrichterdioden zur Gleichrichtung von wechselnden Wärmeströmungen, z.B. durch die Tag/Nachttemperaturschwankung in Außenwänden, ausgenützt wird.

7. Erzeugung von Temperaturdifferenzen nach den Ansprüchen 1 bis 5 dadurch gekennzeichnet, daß bei Wärme/Kälteisolierung inhomogene, thermomotorische Festkörper mit möglichst schlechter Wärmeleitung verwendet werden.

8. Erzeugung von Temperaturdifferenzen nach den Ansprüchen 1 bis 7 dadurch gekennzeichnet, daß pulverförmige oder gekörnte Festkörperkristalle jeweils eine Gradientendotierung aufweisen und entsprechend der Gradientenrichtung ausgerichtet geschichtet sind.

10 ~ 11

~ 12

**Fig. 1**

20

21

23

22

**Fig. 2**

30

31″ { 34

32

31 {

33

31′ {

35

**Fig. 3**

40

41

42

43

**Fig. 4**

**Europäisches Patentamt**

**EUROPÄISCHER RECHERCHENBERICHT**

**0121092**
Nummer der Anmeldung

EP 84 10 2036

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | INSPEC ABSTRACT NO. 82A45338 & J. PHYS. COLLOQ., Band 42, Nr. C-6, Dezember 1981 P.G. KLEMENS "Theory of the attenuation of elastic waves in inhomogeneous solids", Seiten 102-104 | | F 24 F 5/00 H 01 L 49/00 |
| | --- | | |
| A | C. KITTEL "Einführung in die Festkörperphysik", 2. Auflage 1969, R. OLDENBOURG VERLAG, München, Wien * Seiten 231-243 * | | |
| | --- | | |
| A | O. MADELUNG "Festkörpertheorie II" 1972, SPRINGER-VERLAG, Berlin, Heidelberg, New York * Seiten 159-160 * | | |
| | ----- | | **RECHERCHIERTE SACHGEBIETE (Int. Cl. ³)** |
| | | | F 24 F 5/00 H 01 L 49/00 |

Der vorliegende Recherchenbericht wurde für alle Patentansprüche erstellt.

| Recherchenort | Abschlußdatum der Recherche | Prüfer |
|---|---|---|
| BERLIN | 22-05-1984 | ROTHER A H J |